# EUROPÄISCHE PATENTANMELDUNG

(11) **EP 1 259 098 A1**
(43) Veröffentlichungstag der Anmeldung: **20.11.2002**
(21) Anmeldenummer: 02450086.0
(22) Anmeldetag: 11.04.2002
(51) Int. Cl.: H05B 33/08, H05B 37/02

(54) **Verfahren zur Regelung der Lichtverhältnisse in einem von einer in ihrer Farbtemperatur veränderbaren Lichtquelle beleuchteten Bereich**

(30) Priorität: 16.05.2001 AT 7792001
(71) Anmelder: Siemens AG Österreich, 1210 Wien (AT)
(72) Erfinder: Schwigert, Harald, 1120 Wien (AT); Gut, Stefan, 1190 Wien (AT)
(74) Vertreter: Matschnig, Franz, Dipl.-Ing.

(57) **Zusammenfassung**

Verfahren und Vorrichtung zur Regelung der Lichtverhältnisse in einem von einer in ihrer Farbtemperatur (FTE) veränderbaren Lichtquelle (LQU) beleuchteten Bereich (BER), wobei von einer lichtempfindlichen Messvorrichtung (MES) zumindest ein Wert (WER) zumindest eines für die tatsächlichen, von der Lichtquelle (LQU) und ihrem Umgebungslicht hervorgerufenen Lichtverhältnisse (TLI) in dem von der Lichtquelle (LQU) beleuchteten Bereich (BER) charakteristischen Parameters gemessen und von einem Regler (RGL) mit zumindest einem vorgebbaren Sollwert (SO1, SO2) für vorgebbare Lichtverhältnisse in diesem Bereich (BER) verglichen wird, und die Farbtemperatur (FTE) der Lichtquelle (LQU) in Abhängigkeit von der Abweichung des gemessenen Wertes (WER) und des Sollwertes (SOL) von dem Regler (RGL) mittels eines der Lichtquelle (LQU) vorgeschalteten Stellgliedes (STG) verändert wird.

## Beschreibung

Die Erfindung betrifft ein Verfahren zur Regelung der Lichtverhältnisse in einem von einer in ihrer Farbtemperatur veränderbaren Lichtquelle beleuchteten Bereich.

Weiters betrifft die Erfindung eine Vorrichtung zur Regelung der Lichtverhältnisse in einem von einer in ihrer Farbtemperatur veränderbaren Lichtquelle beleuchteten Bereich.

Die Farbtemperatur gibt die durch einen leuchtenden Körper verursachte Farbempfindung an. Sie ist die Temperatur, die ein schwarzer Strahler annehmen müsste, um die gleiche Farbempfindung zu erzeugen.

In der Normalfarbtafel nach der DIN 5033 können die Farborte eines schwarzen Körpers bei verschiedenen Temperaturen eingetragen werden und bilden einen Kurvenzug. Damit auch Farborte, die nicht genau auf diesem Kurvenzug liegen, durch eine Farbtemperatur beschrieben werden können, werden Kurven ähnlichster Form hinzugefügt. Somit ist die Zuordnung einer Farbtemperatur zu Lichtquellen möglich.

Beleuchtungen, bei denen unterschiedliche Farbtemperaturen eingestellt werden können, sind beispielsweise aus dem Bereich der Innenarchitektur - hier vor allem sogenannte Dimmer - bekannt geworden.

Die US 5 559 604 A beschreibt eine Vorrichtung zur Farbanpassung bei der Reproduktion von gedruckten Medien unter verschiedensten Beleuchtungsbedingungen. Hierzu werden colorimetrische Werte in von der Charakteristik einer Farbaus/-wiedergabevorrichtung, wie einem Drucker, in Farbseperationswerte transformiert. Wenn die colorimetrischen Werte einer Objektbeleuchtungsvorrichtung von den Werten einer Standardbeleuchtung abweichen, werden die spektralen Verteilungen der Standardbeleuchtung und der Objektbeleuchtungsvorrichtung an ein neuronales Netz gelegt, welches die von der Farbtemperatur und der spektralen Verteilung der Objektbeleuchtungsvorrichtung abhängigen Farbseperationswerte berechnet. Anhand der von dem neuronalen Netz berechneten Farbseperationswerte erfolgt dann im Druckvorgang eine Reproduktion der Farbwerte ohne die Notwendigkeit der Beleuchtung einer zu reproduzierenden Vorlage mittels einer Normlichtlampe. Auf diese Weise soll eine exakte Farbwiedergabe bei der Reproduktion gewährleistet werden.

Die US 4 947 207 A hat ein Belichtungsgerät für photographisches Material, z. B. Photopapier oder Filme zum Gegenstand, um dessen Empfindlichkeit bezüglich verschiedener Wellenlängen und Lichtintensitäten zu testen. Zur Kontrolle und Aufrechterhaltung bzw. Konstanthaltung der Lichtintensität und Farbtemperatur einer Lichtquelle kommt in diesem Gerät ein Spektroradiometer zum Einsatz. Hierbei befindet sich die Lichtquelle und das zu testende Material in einem geschlossenen Gehäuse, sodass die Lichtverhältnisse in dem Bereich des zu testenden Materials im wesentlichen durch die gehäuseinterne Lichtquelle bestimmt und unabhängig von Umgebungslichtverhältnissen außerhalb des Gehäuses sind.

Die US 5 619 229 A offenbart ein Verfahren zur Veränderung von den Komplementärfarben rot, grün, blau zugeordneten Signalen. Durch das bekannte Verfahren soll bei einer Änderung der Helligkeit und des Kontrastes bei der Wiedergabe von Farbinformation auf einer Ausgabeeinheit, wie beispielsweise einem Bildschirm bzw. Monitor, eine eingestellte Farbtemperatur konstant gehalten werden, was eine übliche Justiermöglichkeit bei Fernsehern und Monitoren darstellt. Nachteilig an der in diesem Dokument beschriebenen Lösung ist vor allem, dass die Farbtemperatur in Abhängigkeit von Umgebungslichtverhältnissen nicht geregelt werden kann.

Die US 4 909 632 A beschreibt eine Methode zur Hilfestellung bei der Auswahl von Farben, Kleidungsstücken, Make-up oder Haartönungen, welche auf die Hautfarbe des Trägers abgestimmt sind, wozu die Farbtemperatur der Haut ermittelt wird. Die Ermittlung der Farbtemperatur der Haut stellt das wesentliche Element der in diesem Dokument offenbarten technischen Lehre dar und kann mit einem Spektrometer oder einer Farbtabelle ermittelt werden.

Die US 4 746 948 A offenbart ein Autofokussierungssystem, welches in einer Spiegelreflexkamera zum Einsatz kommt. Um die Störungen, die bei Autofokussystemen, die mit Umgebungslicht arbeiten, auftreten können, zu vermeiden, erfolgt die Fokussierung gemäß der technischen Lehre der US 4 746 948 A mittels eines von der Kamera erzeugten Infrarotlichts. Dadurch lassen sich störende Effekte bei der Fokussierung, welche üblicherweise durch unterschiedliche Farbtemperaturen hervorgerufen werden vermeiden.

Die JP 9 307 913 A offenbart einen Weißabgleichscontroller aus der Fernseh-Videotechnik, der zur Aufnahme der echten Weißabgleichskorrektur die Farbtemperatur eines empfangenen Bildes mit der Farbtemperatur eines Bildes dessen vorangegangener Weißabgleich geändert wurde, vergleicht.

In der DE 199 09 630 wird eine Vorrichtung zur Veränderung der Farbtemperatur vorgestellt. Bei dieser Vorrichtung werden Leuchtmittel, beispielsweise Leuchtstoffröhren, unterschiedlicher Farben, jedoch keines roter Farbe, sowie ein Diffusor zur Erzeugung von Licht unterschiedlicher Farbtemperatur, zur Beleuchtung eines Raumes erzeugt, wobei die Einstellung der gewünschten Farbtemperatur von einer eigens dafür vorgesehenen Lichtsteueranlage vorgenommen wird.

Nachteilig an den bekannten Vorrichtungen und Methoden ist vor allem, dass mit ihnen keine Regelung der Farbtemperatur einer Lichtquelle in Abhängigkeit von Umgebungslichtverhältnissen durchgeführt werden kann.

Weiters sind Beleuchtungsvorrichtungen mit veränderbarer Farbtemperatur, welche Leuchtdioden verwenden bekannt geworden. Mit den bekannten Beleuchtungsvorrichtungen bzw. Lichtquellen lässt sich fast jede beliebige Farbtemperatur einstellen.

Ausgangspunkt für die Wahrnehmung der Farbtemperatur sind die ihr zugrundeliegenden physikalischen Farbreize, also diejenigen elektromagnetischen Strahlungen im Bereich zwischen 380 und 780 nm, die in das Auge gelangen und dort spezielle Sinneszellen erregen, so dass eine Farbempfindung entsteht. Ein Farbreiz kann auch als Punkt in einem unendlichdimensionalen Raum aufgefasst werden, in dem jede Achse die Intensität einer bestimmten Wellenlänge (beispielsweise in Photonen pro Sekunde) darstellt. Da sich unendlichdimensionale Räume nur schwer darstellen lassen, werden Farbreize meist durch ihre spektrale Strahlungsverteilung charakterisiert, die angibt, wie sich die Strahlungsleistung auf die einzelnen Regionen des Spektrums verteilt.

Bei der Farbwahrnehmung/-empfindung handelt es sich um ein psychologisches Phänomen, das bereits anhand zahlreicher Experimente gut erfasst ist. Es hat sich herausgestellt, dass sich das Wohlbefinden einer Person in einem Raum durch geeignete Wahl der Beleuchtung wesentlich steigern lässt.

Nachteilig an den bekannten Beleuchtungsvorrichtungen ist vor allem, dass sie obwohl ihre Farbtemperatur veränderbar ist, sie die Umgebungslichtverhältnisse nicht berücksichtigen und sich daher eine an den jeweiligen Bedarf angepasste, optimale Beleuchtung nicht realisieren lässt.

Es ist daher eine Aufgabe der Erfindung, einen Weg zu schaffen, der es erlaubt für vorgebbare Situationen, bzw. Anforderungen optimale Lichtverhältnisse zu schaffen.

Diese Aufgabe wird mit einem Verfahren der eingangs genannten Art erfindungsgemäß dadurch gelöst, dass von einer lichtempfindlichen Messvorrichtung zumindest ein Wert zumindest eines für die tatsächlichen, von der Lichtquelle und ihrem Umgebungslicht hervorgerufenen Lichtverhältnisse in dem von der Lichtquelle beleuchteten Bereich charakteristischen Parameters gemessen und von einem Regler mit zumindest einem vorgebbaren Sollwert für vorgebbare Lichtverhältnisse in diesem Bereich verglichen wird, und die Farbtemperatur der Lichtquelle in Abhängigkeit von der Abweichung des gemessenen Wertes und des Sollwertes von dem Regler mittels eines der Lichtquelle zugeordneten Stellgliedes verändert wird.

Es ist ein Verdienst der Erfindung, einen Weg zu schaffen, der es ermöglicht schwankende Lichtverhältnisse ausgleichen zu können. Weiters können mit dem erfindungsgemäßen Verfahren vorgebbare Lichtverhältnisse, beispielsweise Tageslichtverhältnisse, eingestellt und durch eine automatische Anpassung der Farbtemperatur der Lichtquelle an Änderungen der Lichtverhältnisse in dem beleuchten Bereich unabhängig von der Tageszeit bzw. dem Umgebungslicht konstant gehalten werden.

Eine bevorzugte Variante der Erfindung sieht vor, dass der Wert des für die tatsächlichen Lichtverhältnisse charakteristischen Parameters unter Verwendung einer CCD-Kamera gemessen wird.

Eine andere vorteilhafte Variante der Erfindung besteht darin, dass der Wert des für die tatsächlichen Lichtverhältnisse charakteristischen Parameters unter Verwendung eines Interferometers gemessen wird.

Eine weitere Möglichkeit, die tatsächlichen Lichtverhältnisse zu bestimmen, besteht darin, dass der Wert des für die tatsächlichen Lichtverhältnisse charakteristischen Parameters unter Verwendung eines Gitterspektrometers gemessen wird.

Ein einfach zu verwirklichende Variante der Erfindung besteht darin, dass der Wert des für die tatsächlichen Lichtverhältnisse charakteristischen Parameters mit einem Farbtemperaturmessgerät gemessen wird.

Günstigerweise ist der zumindest eine Parameter die spektrale Zusammensetzung des Lichtes.

Bevorzugter weise wird eine Spektralanalyse der tatsächlichen Lichtverhältnisse durchgeführt und das erhaltene Spektrum mit einem vorgebbaren Spektrum verglichen, wobei die Farbtemperatur der Lichtquelle in Abhängigkeit von der Abweichung der beiden Spektren von einander geregelt wird.

Eine andere Variante der Erfindung sieht vor, dass Sättigungswerte von Farbanteilen der tatsächlichen Lichtverhältnisse gemessen und mit vorgebbaren Sättigungswerten verglichen werden, wobei die Farbtemperatur der Lichtquelle in Abhängigkeit von der Abweichung der gemessenen und der vorgebbaren Sättigungswerte geregelt wird.

In einer bevorzugten Ausführungsform der Erfindung werden mehrere Sollwerte für unterschiedliche Solllichtverhältnissen entsprechende Szenarien gespeichert, wobei nach Auswahl eines der Szenarien durch einen Benutzer, die Regelung der Farbtemperatur der Lichtquelle in Abhängigkeit von der Abweichung des gemessenen Wertes von dem dem ausgewählten Lichtverhältnis entsprechenden Sollwert erfolgt.

Eine sehr einfach zu realisierende Variante der Erfindung sieht vor, dass die Farbtemperatur der tatsächlichen Lichtverhältnisse gemessen und mit einer vorgebbaren Farbtemperatur verglichen wird, wobei die Farbtemperatur der Lichtquelle in Abhängigkeit von der Abweichung der gemessenen von der vorgebbaren Farbtemperatur geregelt wird.

Zur Durchführung des erfindungsgemäßen Verfahrens eignet sich insbesondere eine Vorrichtung der eingangs genannten Art, bei welcher eine lichtempfindliche Messvorrichtung vorgesehen ist, die dazu eingerichtet ist zumindest einen Wert zumindest eines für die tatsächlichen, von der Lichtquelle und ihrem Umgebungslicht hervorgerufenen Lichtverhältnisse in dem von der Lichtquelle beleuchteten Bereich charakteristischen Parameters zu messen, und dass ein Regler vorgesehen ist, der dazu eingerichtet ist, den gemessenen Wert mit einem vorgebbaren Lichtverhältnissen für diesen Bereich entsprechenden Sollwert zu vergleichen und die Farbtemperatur der Lichtquelle in Abhängigkeit von der Abweichung des gemessenen Wertes von dem Sollwertes über ein der Lichtquelle zugeordnetes Stellglied zu verändern.

Günstiger weise ist zur Messung der tatsächlichen Lichtverhältnisse eine CCD-Kamera vorgesehen.

In einer anderen vorteilhaften Ausführungsform der Erfindung ist zur Messung der tatsächlichen Lichtverhältnisse ein Interferometer vorgesehen.

Eine weitere Variante der Erfindung sieht vor, dass zur Messung der tatsächlichen Lichtverhältnisse ein Gitterspektrometer vorgesehen ist.

Eine besonders einfach zu realisierende Variante der Erfindung sieht vor, dass die Messvorrichtung ein Farbtemperaturmessgerät ist.

Vorteilhafterweise ist die Vorrichtung dazu eingerichtet, die Farbtemperatur der tatsächlichen Lichtverhältnisse zu messen und mit einer vorgebbaren Farbtemperatur zu vergleichen sowie die Farbtemperatur der Lichtquelle in Abhängigkeit von der Abweichung der gemessenen von der vorgebbaren Farbtemperatur zu regeln.

Weitere Vorteile lassen sich dadurch erzielen, dass die Vorrichtung dazu eingerichtet ist, eine Spektralanalyse der tatsächlichen Lichtverhältnisse durchzuführen, das erhaltene Spektrum mit einem vorgebbaren Spektrum zu vergleichen und die Farbtemperatur in Abhängigkeit von der Abweichung der Spektren zu regeln.

Eine andere günstige Variante der Erfindung sieht vor, dass die Vorrichtung dazu eingerichtet ist, die Sättigungswerte von Farbanteilen der tatsächlichen Lichtverhältnisse zu messen, mit vorgebbaren Sättigungswerten zu vergleichen und die Farbtemperatur der Lichtquelle in Abhängigkeit von der Abweichung der gemessenen und der vorgebbaren Sättigungswerte zu regeln.

Eine bevorzugte Variante der Erfindung besteht darin, dass die Vorrichtung dazu eingerichtet ist, mehrere Sollwerte für unterschiedlichen Solllichtverhältnissen entsprechenden Szenarien zu speichern, wobei der Regler dazu eingerichtet ist, nach Auswahl eines der Szenarien durch einen Benutzer, die Regelung der Farbtemperatur der Lichtquelle in Abhängigkeit von der Abweichung des gemessenen Wertes von dem dem ausgewählten Lichtverhältnis entsprechenden Sollwert durchzuführen.

Die Benutzerfreundlichkeit lässt sich dadurch erhöhen, dass die Vorrichtung eine Eingabe zur Auswahl eines Lichtszenariums aufweist.

In einer bevorzugten Ausführungsform der Erfindung weist die Lichtquelle Leuchtdioden auf.

Die Erfindung samt weiterer Vorteile wird im folgenden anhand einiger nicht einschränkender Ausführungsbeispiele, die in der Zeichnung näher erläutert sind dargestellt. In dieser zeigen schematisch:
Fig. 1 ein Blockschaltbild einer erfindungsgemäßen Vorrichtung zur Regelung der Lichtverhältnisse in einem von einer in ihrer Farbtemperatur veränderbaren Lichtquelle beleuchteten Bereich,
Fig. 2 eine Eingabe zur Auswahl eines vorgebbaren Lichtszenariums,
Fig. 3 eine erste Variante eines Reglers einer erfindungsgemäßen Vorrichtung
Fig. 4 ein weiteres Blockschaltbild einer erfindungsgemäßen Vorrichtung zur Regelung der Lichtverhältnisse in einem von einer in ihrer Farbtemperatur veränderbaren Lichtquelle beleuchteten Bereich und
Fig. 5 eine zweite Variante eines Reglers einer erfindungsgemäßen Vorrichtung.

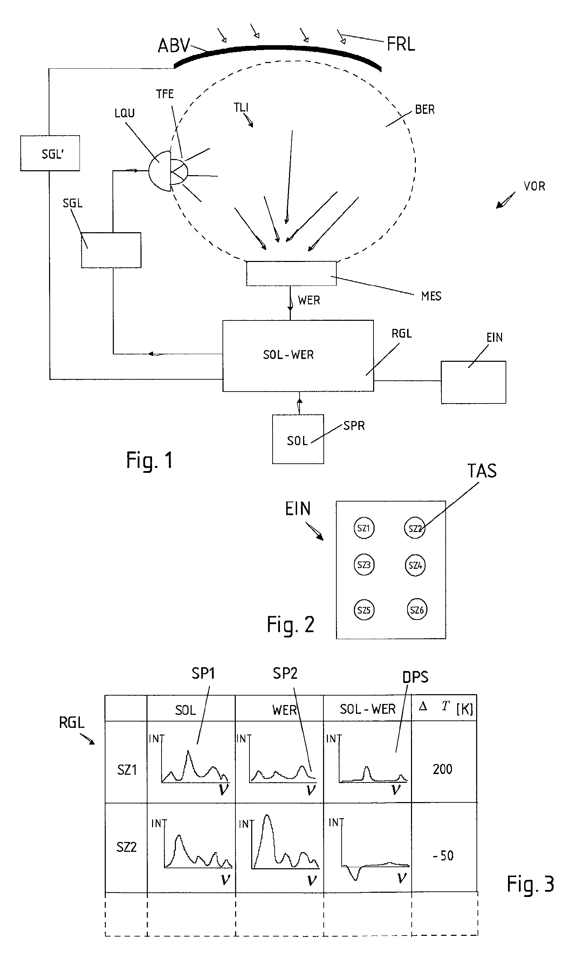

Gemäß Fig. 1 weist eine erfindungsgemäße Vorrichtung VOR zur Regelung der Farbtemperatur FTE einer in ihrer Farbtemperatur FTE veränderbaren Lichtquelle LQU eine lichtempfindliche Messvorrichtung MES auf, mit welcher ein Wert WER eines für die tatsächlichen Lichtverhältnisse TLI in dem von der Lichtquelle LQU beleuchteten Bereich BER charakteristischen Parameters gemessen wird.

Dieser Parameter kann beispielsweise die spektrale Zusammensetzung, die Wellenlänge, spektrale Intensität, die Farbtemperatur oder die Sättigung einzelner Farbanteile des Lichtes in dem Bereich BER um die Lichtquelle LQU sein.

Zur Messung des Parameters können Farbtemperaturmessgeräte, Gitterspektrometer, Interferometer, CCD-Kameras oder andere dem Fachmann zur Durchführung dieser Aufgabe bekannte Vorrichtungen und Verfahren verwendet werden.

Der gemessene Wert WER des Parameters wird mit einem Sollwert SOL, durch den vorgebbare Lichtverhältnisse für den Bereich BER festgelegt werden, verglichen. Zum Vergleich des Sollwertes SOL mit dem gemessenen Wert WER ist ein Regler RGL vorgesehen, der in Abhängigkeit von der Abweichung der beiden Werte voneinander die Farbtemperatur FTE der Lichtquelle LQU über ein Stellglied SGL ändert, sodass in dem von der Lichtquelle LQU beleuchteten Bereich BER die gewünschten Lichtverhältnisse erhalten werden. Gegebenfalls kann, wie weiter unten genauer beschrieben zusätzlich zu der Farbtemperatur der Lichtquelle LQU über ein zweites Stellglied STG' eine Abschattungsvorrichtung ABV zur Abschattung von Fremdlicht FRL betätigt werden.

Zur Speicherung unterschiedlicher Sollwerte SOL für verschiedene Solllichtverhältnisse kann eine Speichereinheit SPR vorgesehen sein. Der Regler RGL kann zur Ermittlung der Abweichung des gemessenen Wertes WER von einem Sollwert SOL auf den Speicher SPR zugreifen und einen von einem Benutzer über eine Eingabe EIN ausgewählten Sollwert SOL zur Berechnung verwenden.

Nach Fig. 2 weist die Eingabe EIN die Möglichkeit auf, unter mehreren Szenarien SZ1, SZ2, SZ3, SZ4, SZ5, SZ6 für die Solllichteverhältnisse in dem von der Lichtquelle LQU beleuchteten Bereich zu wählen. Durch Betätigen einer einem Szenarium zugeordneten Taste TAS, verwendet der Regler RGL den auf diese Weise ausgewählten, einem Szenario zugeordneten, in der Speichereinheit SPR abgelegten Sollwert SOL zur Berechnung der Abweichung von dem gemessenen Wert WER. Die dem ausgewählten Szenarium SZ1-SZ6 entsprechenden Solllichtverhältnisse werden von dem Regler RGL mittels Veränderung der Farbtemperatur FTE der Lichtquelle LQU hergestellt.

Die Szenarien SZ1-SZ6 können darauf abgestimmt sein bestimmte Lichtverhältnisse an einem anderen Ort als den aktuellen zu antizipieren. So kann beispielsweise ein Szenarium SZ1 für ein Schminklicht den Lichtverhältnissen in einem Ballsaal oder ähnlichem entsprechen, während ein Szenarium SZ2 den Tageslichtverhältnissen während des Sonnenhöchststandes entspricht. Prinzipiell lassen sich beliebig viele Szenarien SZ1-SZ6 vorgeben und die entsprechenden Sollwerte SOL definieren.

Gemäß Fig. 3 können, falls der Parameter die spektrale Zusammensetzung des tatsächlichen Lichtes in dem von der Lichtquelle LQU beleuchteten Bereich BER ist, sowohl die Sollwerte SOL als auch die gemessenen Wert WER als Spektren SP1, SP2 vorliegen. Die beiden miteinander zu vergleichenden Spektren SP1, SP2 können von dem Regler RGL voneinander abgezogen werden, wobei dem erhaltenen Differenzspektrum DSP eine vorzunehmende Änderung *ΔFTE* der Farbtemperatur FTE der Lichtquelle LQU entspricht. Um die Solllichtverhältnisse FTE +/- *ΔFTE zu* erreichen, muss die Farbtemperatur FTE der Lichtquelle LQU um die erforderliche Änderung *ΔFTE* der Farbtemperatur FTE nachgestellt werden, wobei die Abweichung von Soll- und Istwert innerhalb der Systemgrenzen der Vorrichtung VOR minimiert wird.

Liegt die gewünschte Farbtemperatur unter der Farbtemperatur FTE in dem beleuchteten Bereich BER abzüglich der Farbtemperatur der Lichtquelle LQU, so kann eine mit dem Regelkreis gekoppelte Abschattung, von Fremdlicht - Hintergrundlicht - erfolgen. Auf diese Weise lassen sich nicht über die Farbtemperatur der Lichtquelle LQU regelbare, störende Fremdlichtanteile aus dem beleuchteten Bereich BER eliminieren.

Liegt der beleuchtete Bereich BER beispielsweise an einem Fenster, so kann eine gegebenenfalls vollständige Abschattung von Tageslicht durch eine mit dem Regelkreis gekoppelte elektronisch betätigbare Jalousie erfolgen, wobei die Farbtemperatur der Lichtquelle LQU solange erhöht wird, bis die gewünschte Farbtemperatur FTE erreicht ist.

Die Änderung *ΔFTE* der Farbtemperatur FTE der Lichtquelle LQU wird von dem Regler RGL an das Stellglied SGL übermittelt, mittels dessen die Sollfarbtemperatur FTE +/*ΔFTE* der Lichtquelle LQU eingestellt wird. Ist die Änderung *ΔFTE* der Farbtemperatur FTE größer als die momentane Farbtemperatur FTE der Lichtquelle LQU so kann der Regler RGL über ein Stellglied SGL' eine Abschattung von Fremdlicht FRL in den beleuchteten Bereich BER mittels der Abschattungsvorrichtung ABV, z. B, wie bereits oben erwähnt, mittels einer elektronisch betätigbaren Jalousie.

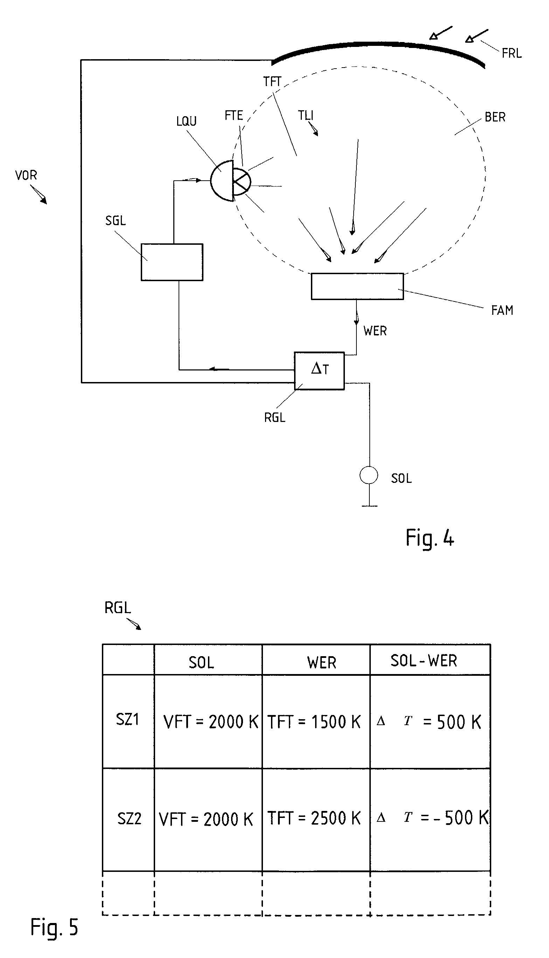

Nach Fig. 4 ist in einer Variante der Erfindung ein Farbtemperaturmessgerätes FAR vorgesehen. Der Parameter ist in diesem Fall die Farbtemperatur in dem von der Lichtquelle LQU beleuchteten Bereich BER. Der Regler RGL vergleicht in diesem Fall die Farbtemperatur VFT des einzustellenden bzw. gewünschten Lichtszenariums SZ1-SZ6 mit der gemessenen Farbtemperatur TFT (Fig.5). Die Regelung der Farbtemperatur TFT erfolgt, wie bereits oben beschrieben, über das der Lichtquelle LQU vorgeschaltete Stellglied SGL.

Im Fall einer Beleuchtungsvorrichtung mit Leuchtdioden unterschiedlicher Farben als Lichtquellen kann das Stellglied SGL Schaltnetzteile aufweisen, deren Ausgangsspannungen bzw. Ausgangsströme über den Regler RGL geregelt werden können, wobei für Leuchtdioden gleicher Farbe je ein gemeinsames Schaltnetzteil vorgesehen sein kann.

Über die Schaltnetzteile kann die Ausgangsspannung und/oder der Ausgangsstrom, die der jeweiligen Betriebsspannung bzw. dem jeweiligen Betriebsstrom der Leuchtdioden proportional sind und somit die Helligkeit/Intensität der Leuchtdioden reguliert werden. Es hat sich herausgestellt, dass sich eine besonders große spektrale Bandbreite der Farbtemperatur einstellen lässt wenn die verwendeten Leuchtdioden die Farben rot, grün und blau aufweisen. Die Leuchtdioden die einer Farbe zugeordnet sind, können dabei zu Blöcken zusammengefasst werden.

Als Stellglied SGL kann auch ein für alle Leuchtdioden gemeinsames Schaltnetzteil vorgesehen sein, welches zur Steuerung der Farbtemperatur getrennt regelbare Ausgänge aufweist, die den Leuchtdioden einer Farbe zugeordnet sind. Als steuerbares Schaltnetzteil kann beispielsweise ein Mehrkanal-Dimmer verwendet werden.

Natürlich sind auch andere Arten von Stellgliedern SGL zur Veränderung der Farbtemperatur FTE der Lichtquelle LQU denkbar, dem Fachmann sind derartige Vorrichtungen und Verfahren in großer Zahl bekannt.

Eine andere hier nicht dargestellte Ausführungsmöglichkeit der Erfindung besteht darin, Sättigungswerte von Farbanteilen der tatsächlichen Lichtverhältnisse, beispielsweise mittels einer Digitalkamera und einem dazu eingerichteten Computer zu messen und mit vorgebbaren Sättigungswerten zu vergleichen, wobei die Farbtemperatur der Lichtquelle in Abhängigkeit von der Abweichung der gemessenen und der vorgebbaren Sättigungswerte geregelt wird.

## Patentansprüche

1. Verfahren zur Regelung der Lichtverhältnisse in einem von einer in ihrer Farbtemperatur (FTE) veränderbaren Lichtquelle (LQU) beleuchteten Bereich (BER) **dadurch gekennzeichnet, dass** von einer lichtempfindlichen Messvorrichtung (MES) zumindest ein Wert (WER) zumindest eines für die tatsächlichen, von der Lichtquelle (LQU) und ihrem Umgebungslicht hervorgerufenen Lichtverhältnisse (TLI) in dem von der Lichtquelle (LQU) beleuchteten Bereich (BER) charakteristischen Parameters gemessen und von einem Regler (RGL) mit zumindest einem vorgebbaren Sollwert (SO1, SO2) für vorgebbare Lichtverhältnisse in diesem Bereich (BER) verglichen wird, und die Farbtemperatur (FTE) der Lichtquelle (LQU) in Abhängigkeit von der Abweichung des gemessenen Wertes (WER) und des Sollwertes (SOL) von dem Regler (RGL) mittels eines der Lichtquelle (LQU) zugeordneten Stellgliedes (STG) verändert wird.

2. Verfahren nach Anspruch 1, **dadurch gekennzeichnet, dass** der Wert (WER) des für die tatsächlichen Lichtverhältnisse charakteristischen Parameters unter Verwendung einer CCD-Kamera gemessen wird.

3. Verfahren nach Anspruch 1 oder 2, **dadurch gekennzeichnet, dass** der Wert (WER) des für die tatsächlichen Lichtverhältnisse charakteristischen Parameters unter Verwendung eines Interferometers gemessen wird.

4. Verfahren nach einem der Ansprüche 1 bis 3, **dadurch gekennzeichnet, dass** der Wert (WER) des für die tatsächlichen Lichtverhältnisse charakteristischen Parameters unter Verwendung eines Gitterspektrometers gemessen wird.

5. Verfahren nach Anspruch 1, **dadurch gekennzeichnet, dass** der Wert (WER) des für die tatsächlichen Lichtverhältnisse charakteristischen Parameters mit einem Farbtemperaturmessgerät (FAM) gemessen wird.

6. Verfahren nach Anspruch 5, **dadurch gekennzeichnet, dass** die Farbtemperatur der tatsächlichen Lichtverhältnisse gemessen und mit einer vorgebbaren Farbtemperatur verglichen wird, wobei die Farbtemperatur (FTE) der Lichtquelle (LQU) in Abhängigkeit von der Abweichung der gemessenen (TFT) von der vorgebbaren Farbtemperatur (VFT) geregelt wird.

7. Verfahren nach einem der Ansprüche 1 bis 4, **dadurch gekennzeichnet, dass** der zumindest eine Parameter die spektrale Zusammensetzung der tatsächlichen Lichtverhältnisse Lichtes (TLI) ist.

8. Verfahren nach Anspruch 7, **dadurch gekennzeichnet, dass** eine Spektralanalyse der tatsächlichen Lichtverhältnisse (TLI) durchgeführt und das erhaltene Spektrum (SP1) mit einem vorgebbaren Spektrum (SP2) verglichen wird, wobei die Farbtemperatur (FTE) der Lichtquelle in Abhängigkeit von der Abweichung (DPS) der beiden Spektren (SP1, SP2) voneinander geregelt wird.

9. Verfahren nach einem der Ansprüche 1 bis 8, **dadurch gekennzeichnet, dass** Sättigungswerte von Farbanteilen der tatsächlichen Lichtverhältnisse (TLI) gemessen und mit vorgebbaren Sättigungswerten verglichen werden, wobei die Farbtemperatur (TFE) der Lichtquelle (LQU) in Abhängigkeit von der Abweichung der gemessenen und der vorgebbaren Sättigungswerte geregelt wird.

10. Verfahren nach einem der Ansprüche 1 bis 9, **dadurch gekennzeichnet, dass** mehrere Sollwerte (SOL) für unterschiedliche Solllichtverhältnissen entsprechende Szenarien (SZ1, SZ2, SZ3, SZ4, SZ5, SZ6) gespeichert werden, wobei nach Auswahl eines der Szenarien (SZ1-SZ6) durch einen Benutzer die Regelung der Farbtemperatur (FTE) der Lichtquelle (LQU) in Abhängigkeit von der Abweichung des gemessenen Wertes (WER) von dem dem ausgewählten Lichtverhältnis entsprechenden Sollwert (SOL) erfolgt.

11. Vorrichtung zur Regelung der Lichtverhältnisse in einem von einer in ihrer Farbtemperatur (FTE) veränderbaren Lichtquelle (LQU) beleuchteten Bereich (BER), **dadurch gekennzeichnet, dass** eine lichtempfindliche Messvorrichtung (MES) vorgesehen ist, die dazu eingerichtet ist zumindest einen Wert (WE1, WE2) zumindest eines für die tatsächlichen, von der Lichtquelle (LQU) und ihrem Umgebungslicht hervorgerufenen Lichtverhältnisse (TLI) in dem von der Lichtquelle (LQU) beleuchteten Bereich (BER) charakteristischen Parameters zu messen, und dass ein Regler (RGL) vorgesehen ist, der dazu eingerichtet ist, den gemessenen Wert (WER) mit einem vorgebbaren Lichtverhältnissen für diesen Bereich (BER) entsprechenden Sollwert (SO1, SO2) zu vergleichen und die Farbtemperatur (FTE) der Lichtquelle (LQU) in Abhängigkeit von der Abweichung des gemessenen Wertes (WE1, WE2) von dem Sollwertes (SO1, SO2) über ein der Lichtquelle (LQU) zugeordnetes Stellglied (SGL) zu verändern.

12. Vorrichtung nach Anspruch 11, **dadurch gekennzeichnet, dass** die Messvorrichtung (MES) eine CCD-Kamera ist.

13. Vorrichtung nach Anspruch 10 oder 11, **dadurch gekennzeichnet, dass** die Messvorrichtung (MES) ein Interferometer aufweist.

14. Vorrichtung nach einem der Ansprüche 10 bis 13, **dadurch gekennzeichnet, dass** die Messvorrichtung (MES) ein Gitterspektrometer aufweist.

15. Vorrichtung nach Anspruch 10, **dadurch gekennzeichnet, dass** die Messvorrichtung ein Farbtemperaturmessgerät (FAM) ist.

16. Vorrichtung nach Anspruch 15, **dadurch gekennzeichnet, dass** sie dazu eingerichtet ist, die Farbtemperatur (TFT) der tatsächlichen Lichtverhältnisse (TLI) zu messen und mit einer vorgebbaren Farbtemperatur (VFT) zu vergleichen sowie die Farbtemperatur der Lichtquelle (LQU) in Abhängigkeit von der Abweichung der gemessenen von der vorgebbaren Farbtemperatur zu regeln.

17. Vorrichtung nach einem der Ansprüche 10 bis 14, **dadurch gekennzeichnet, dass** sie dazu eingerichtet ist, eine Spektralanalyse der tatsächlichen Lichtverhältnisse durchzuführen, das erhaltene Spektrum (SP1) mit einem vorgebbaren Spektrum (SP2) zu vergleichen und die Farbtemperatur in Abhängigkeit von der Abweichung (DES) der Spektren voneinander zu regeln.

18. Vorrichtung nach einem der Ansprüche 10 bis 17, **dadurch gekennzeichnet, dass** sie dazu eingerichtet ist, die Sättigungswerte von Farbanteilen der tatsächlichen Lichtverhältnisse zu messen, mit vorgebbaren Sättigungswerten zu vergleichen und die Farbtemperatur der Lichtquelle in Abhängigkeit von der Abweichung der gemessenen und der vorgebbaren Sättigungswerte zu regeln.

19. Vorrichtung nach einem der Ansprüche 10 bis 18, **dadurch gekennzeichnet, dass** sie dazu eingerichtet ist, mehrere Sollwerte (SOL) für unterschiedlichen Solllichtverhältnissen entsprechenden Szenarien (SZ1, SZ2, SZ3, SZ4, SZ5, SZ6) zu speichern, wobei der Regler (RGL) dazu eingerichtet ist, nach Auswahl eines der Szenarien (SZ1-SZ6) durch einen Benutzer, die Regelung der Farbtemperatur (FTE) der Lichtquelle (LQU) in Abhängigkeit von der Abweichung des gemessenen Wertes (WER) von dem dem ausgewählten Lichtverhältnis entsprechenden Sollwert (SOL) durchzuführen.

20. Vorrichtung nach Anspruch 19, **dadurch gekennzeichnet, dass** sie eine Eingabe EIN zur Auswahl eines Lichtszenariums (SZ1, SZ2, SZ3, SZ4, SZ5, SZ6, SZ7) aufweist.

21. Vorrichtung nach einem der Ansprüche 11 bis 20, **dadurch gekennzeichnet, dass** die Lichtquelle (LQU) Leuchtdioden (LED) aufweist.
